# EUROPEAN PATENT APPLICATION

(11) **EP 4 844 352 A1**
(43) Date of publication of application: **25.11.2026**
(21) Application number: 25741824.4
(22) Date of filing: 07.01.2025
(51) Int. Cl.: G01J 5/00, C23C 16/52, C30B 25/16, G01J 5/80, H01L 21/31, H01L 21/205

(54) **TEMPERATURE MEASUREMENT DEVICE, TEMPERATURE MEASUREMENT METHOD, AND TEMPERATURE MEASUREMENT PROGRAM, AND WAFER PRODUCTION APPARATUS**

(30) Priority: 16.01.2024 JP 2024004918
(71) Applicant: Epicrew Corporation, Ohmura-shi, Nagasaki 856-0022 (JP)
(72) Inventor: OKABE Akira, Ohmura-shi, Nagasaki 856-0022 (JP); YAMAOKA Tomonori, Ohmura-shi, Nagasaki 856-0022 (JP); TAKEUCHI Atsuki, Ohmura-shi, Nagasaki 856-0022 (JP); MAEDA Yukito, Ohmura-shi, Nagasaki 856-0022 (JP)
(74) Representative: AWA Sweden AB
(86) International application number: PCT/JP2025/000194
(87) International publication number: WO 2025/154579

(57) **Abstract**

A temperature measurement device is provided that computes a temperature change amount of a measurement target by excluding, from actually measured radiance, an influence of radiance caused by a member of a chamber in a situation in which a temperature of a silicon wafer serving as the measurement target is indirectly measured. The temperature measurement device includes: a chamber that houses a measurement target object; a heating unit; a chamber window portion at a position of the chamber facing the measurement target object; a temperature measurement unit that measures temperatures of the measurement target object and the chamber window portion; and a computation unit that computes the temperature of the measurement target object from a detection value of the temperature measurement unit. The computation unit includes a conversion unit, a condition acquisition unit, a detection value acquisition unit, and a temperature correction unit. The conversion unit generates conversion data of a temperature change amount of the measurement target object heated in the chamber, the conversion data corresponding to a temperature change amount of the chamber window portion, on the basis of an actually measured temperature computed from the detection value of the temperature measurement unit. The condition acquisition unit acquires a heating condition for the measurement target object in the chamber. The detection value acquisition unit acquires the detection value of the temperature measurement unit. The temperature correction unit corrects the actually measured temperature computed from the detection value of the temperature measurement unit by using the conversion data and estimates the temperature of the measurement target object.

## Description

### BACKGROUND OF THE INVENTION

### 1. Field of the Invention

The present invention relates to a temperature measurement device, a temperature measurement method, a temperature measurement program, and a wafer production apparatus. More specifically, the present invention is directed to a temperature measurement device, a method, and a program for measuring a temperature of a measurement target object indirectly with an influence of an amount of radiant heat from surrounding members excluded, and is also directed to a wafer production apparatus including the temperature measurement device.

### 2. Description of Related Art

In production of silicon wafers serving as components of semiconductors, epitaxial growth apparatuses are currently widely used. In such an apparatus, a silicon wafer is housed in a chamber, and the temperature of the silicon wafer is measured by a pyrometer (radiation thermometer) installed outside the chamber (see patent documents 1, 2, 3, and 4, for example).

In a conventional apparatus, the temperature of the silicon wafer is measured by the pyrometer with a member of a window of the chamber interposed therebetween. Accordingly, a temperature value actually measured is not a pure temperature of the silicon wafer serving as the measurement target, but is a measured value that also includes radiant heat (radiance) of the member of the window of the chamber.

In a reaction for epitaxial growth of a silicon wafer, precise control of a heating temperature is needed in accordance with the type, flow rate, and other conditions of gas introduced into the chamber. However, current techniques rely on indirect temperature measurement. At present, processing precision needed for silicon wafers is becoming increasingly strict, and variations in the epitaxial growth reaction affect quality and yield. Accordingly, a technique has been needed that measures, as purely as possible, the temperature of the silicon wafer serving as the measurement target with indirect temperature measurement still used.

### Prior Art Documents

### Patent Documents

Patent Document 1: Japanese National Publication of International Patent Application No. 2009-507997
Patent Document 2: Japanese Unexamined Patent Application Publication No. 2016-129162
Patent Document 3 : Japanese Unexamined Patent Application Publication No. 2018-44915
Patent Document 4: Japanese Unexamined Patent Application Publication No. 2022-144083

### SUMMARY OF THE INVENTION

### Problems to be Solved by the Invention

The present invention has been made in view of the above points, and provides a temperature measurement device, a temperature measurement method, and a temperature measurement program that compute a temperature change amount of a measurement target more accurately by excluding, from actually measured radiance, an influence of radiance caused by a member of a chamber in a situation in which the temperature of a silicon wafer serving as the measurement target is indirectly measured. The present invention further provides a wafer production apparatus that improves accuracy of temperature control during wafer production by including the temperature measurement device.

### Means for Solving the Problems

Specifically, a temperature measurement device according to an embodiment includes: a chamber of an epitaxial growth apparatus, the chamber housing a measurement target object therein; a heating unit that heats the measurement target object; a chamber window portion provided at a position of the chamber facing the measurement target object; a temperature measurement unit installed outside the chamber window portion of the epitaxial growth apparatus and configured to measure a temperature of the measurement target object through the chamber window portion and to measure a temperature of the chamber window portion; and a computation unit that computes the temperature of the measurement target object from a detection value of the temperature measurement unit. The computation unit includes: a conversion unit that generates conversion data of a temperature change amount of the measurement target object heated in the chamber, the conversion data corresponding to a temperature change amount of the chamber window portion, on the basis of an actually measured temperature computed from the detection value of the temperature measurement unit; a condition acquisition unit that acquires a heating condition for the measurement target object in the chamber; a detection value acquisition unit that acquires the detection value of the temperature measurement unit; and a temperature correction unit that corrects the actually measured temperature computed from the detection value of the temperature measurement unit by using the conversion data and estimates the temperature of the measurement target object.

A wafer production apparatus according to an embodiment includes: a chamber of an epitaxial growth apparatus, the chamber housing a silicon wafer therein; a heating unit that heats the silicon wafer; a chamber window portion made of quartz and provided at a position of the chamber facing the silicon wafer; a temperature measurement unit installed outside the chamber window portion of the epitaxial growth apparatus and configured to measure a temperature of a measurement target object through the chamber window portion and to measure a temperature of the chamber window portion; and a computation unit that computes the temperature of the silicon wafer from a detection value of the temperature measurement unit. The computation unit includes: a conversion unit that generates conversion data of a temperature change amount of the silicon wafer heated in the chamber, the conversion data corresponding to a temperature change amount of the chamber window portion, on the basis of an actually measured temperature computed from the detection value of the temperature measurement unit; a condition acquisition unit that acquires a heating condition for the silicon wafer in the chamber; a detection value acquisition unit that acquires the detection value of the temperature measurement unit; and a temperature correction unit that corrects the actually measured temperature computed from the detection value of the temperature measurement unit by using the conversion data and estimates the temperature of the silicon wafer.

In the wafer production apparatus, a temperature adjustment unit that cools the chamber may be provided outside the chamber, and the computation unit may further include a temperature adjustment controller that controls an output of the temperature adjustment unit on the basis of the temperature of the silicon wafer estimated by the temperature correction unit.

### Advantageous Effects of the Invention

According to the temperature measurement device of the present invention, the temperature measurement device includes: the chamber of the epitaxial growth apparatus, the chamber housing the measurement target object therein; the heating unit that heats the measurement target object; the chamber window portion provided at the position of the chamber facing the measurement target object; the temperature measurement unit installed outside the chamber window portion of the epitaxial growth apparatus and configured to measure the temperature of the measurement target object through the chamber window portion and to measure the temperature of the chamber window portion; and the computation unit that computes the temperature of the measurement target object from the detection value of the temperature measurement unit. The computation unit includes: the conversion unit that generates the conversion data of the temperature change amount of the measurement target object heated in the chamber, the conversion data corresponding to the temperature change amount of the chamber window portion, on the basis of the actually measured temperature computed from the detection value of the temperature measurement unit; the condition acquisition unit that acquires the heating condition for the measurement target object in the chamber; the detection value acquisition unit that acquires the detection value of the temperature measurement unit; and the temperature correction unit that corrects the actually measured temperature computed from the detection value of the temperature measurement unit by using the conversion data and estimates the temperature of the measurement target object. This allows the temperature change amount of the measurement target object to be computed more accurately by excluding, from actually measured radiance, the influence of radiance caused by the member of the chamber in a situation in which the temperature of the silicon wafer serving as the measurement target is indirectly measured. In addition, application to the wafer production apparatus allows the temperature change amount of the silicon wafer serving as the measurement target object to be computed accurately.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 shows a schematic configuration diagram illustrating a wafer production apparatus including a temperature measurement device according to an embodiment,
FIG. 2 shows a schematic block diagram illustrating a configuration of a computation unit of the temperature measurement device,
FIG. 3 shows a schematic block diagram illustrating a functional configuration of the computation unit of FIG. 2,
FIG. 4 shows a conceptual diagram during temperature measurement of a measurement target object,
FIGS. 5A to 5C include graphs relating to an operation of a temperature adjustment unit for a chamber window portion:

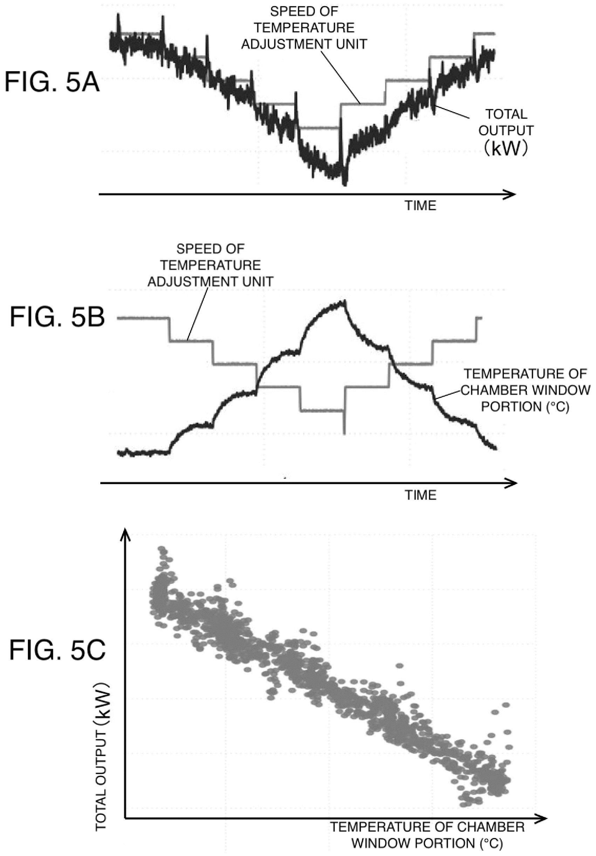

   FIG. 5A shows a graph indicating an output of a heating unit (halogen lamp) if the output of the temperature adjustment unit is intentionally changed stepwise under control for maintaining a temperature of a wafer serving as a measurement target object constant,
   FIG. 5B shows a graph indicating a temperature change of the chamber window portion measured by a temperature measurement unit at that time,
   FIG. 5C shows a graph illustrating a relationship between the temperature of the chamber window portion and a total output of the heating unit (halogen lamp),

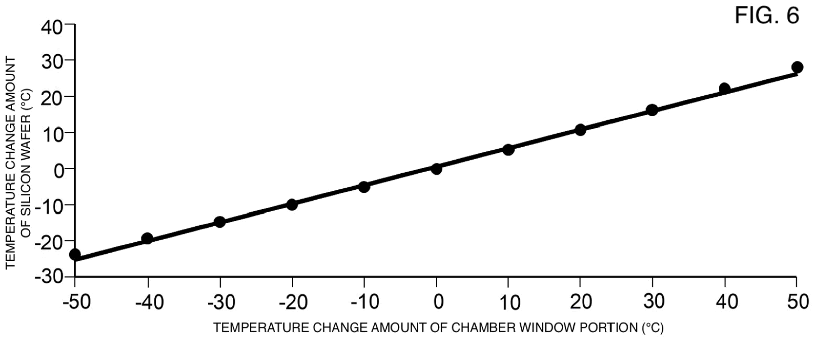

FIG. 6 shows a graph obtained by setting conditions and computing how much the temperature of a wafer serving as a measurement target object apparently changes if the temperature of the chamber window portion changes,

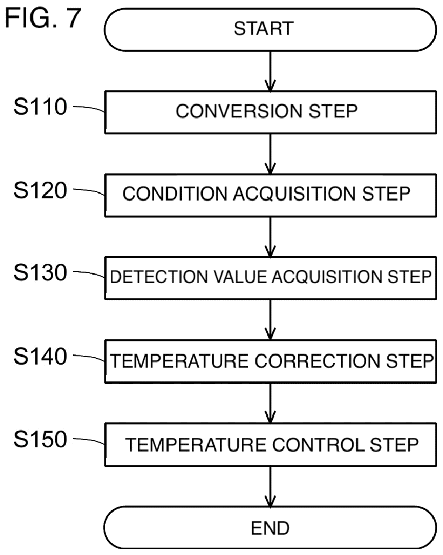

FIG. 7 shows a flowchart illustrating a processing procedure in the temperature measurement device according to the embodiment,

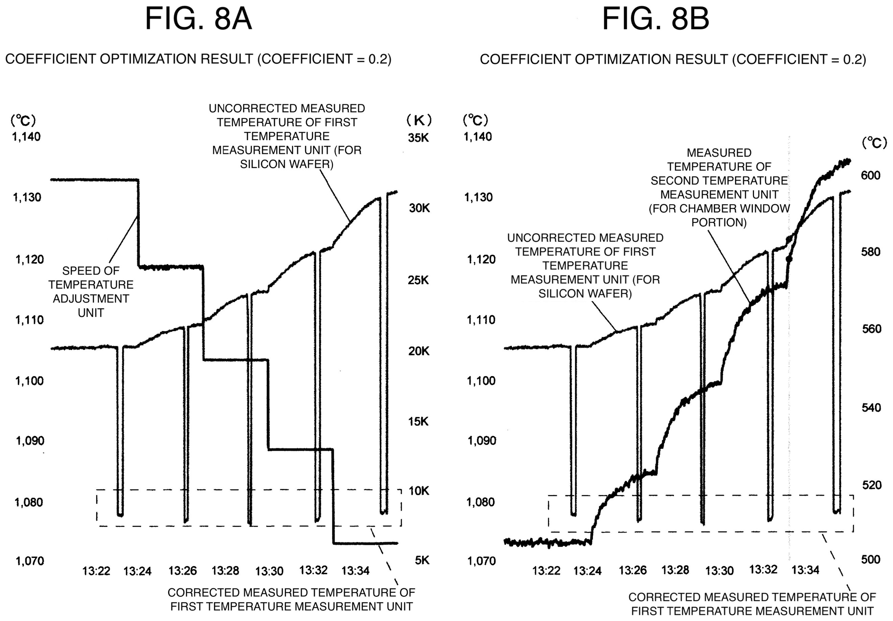

FIGS. 8A and 8B show a verification example of temperature measurement according to the embodiment:
FIG. 8A shows a graph indicating a measured temperature of a first temperature measurement unit and a speed of a temperature adjustment unit,
FIG. 8B shows a graph indicating the measured temperature of the first temperature measurement unit and a measured temperature of a second temperature measurement unit,

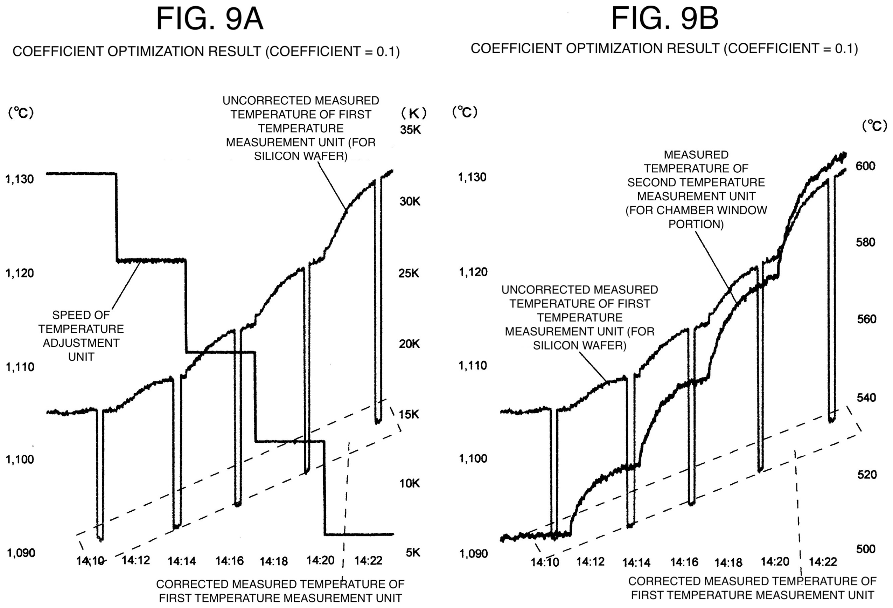

FIGS. 9A and 9B show a verification example of temperature measurement if a coefficient is changed from that in FIGS. 8A and 8B:
   FIG. 9A shows a graph indicating a measured temperature of a first temperature measurement unit and a speed of a temperature adjustment unit,
   FIG. 9B shows a graph indicating the measured temperature of the first temperature measurement unit and a measured temperature of a second temperature measurement unit, and

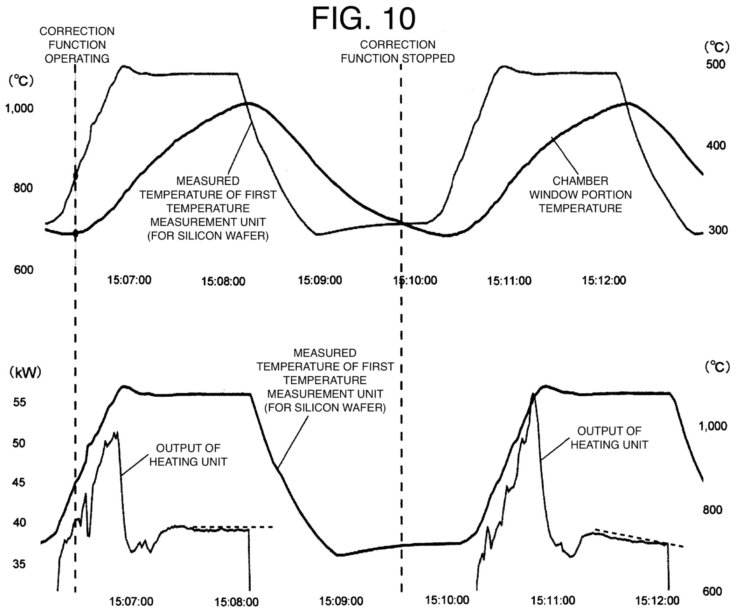

FIG. 10 shows a graph showing a comparison between presence and absence of a correction function.

### DETAILED DESCRIPTION OF EMBODIMENTS

A temperature measurement device according to an embodiment is mainly connected to a wafer production apparatus (specifically, an epitaxial apparatus or an epitaxial growth apparatus) that produces wafers such as silicon wafers for semiconductors. The temperature measurement device is used for temperature measurement of a wafer and control of a heating condition during epitaxial growth of the wafer.

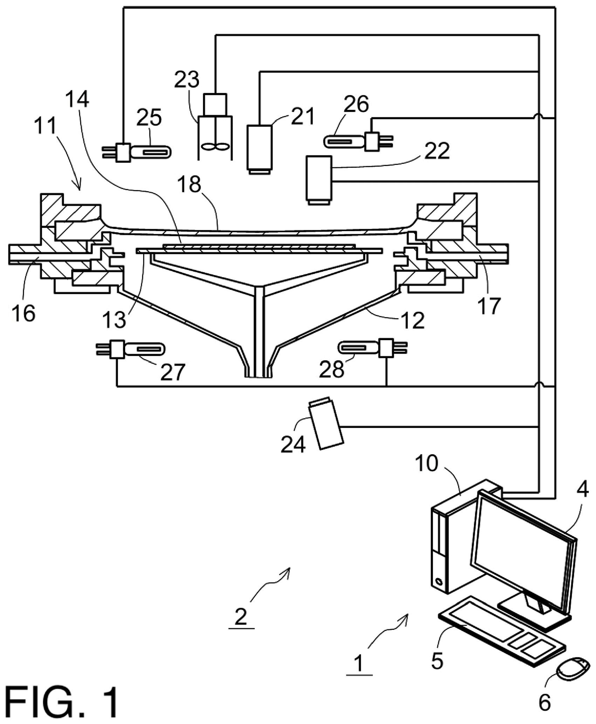

FIG. 1 shows a schematic configuration diagram illustrating a temperature measurement device 1 according to the embodiment and a wafer production apparatus 2 including the temperature measurement device 1. That is, the wafer production apparatus 2 corresponds to an apparatus obtained by combining a chamber 11 of an epitaxial growth apparatus that performs epitaxial growth on a silicon wafer with a computer 10. The number of chambers 11 combined with the computer 10 may be one or may be a plurality as appropriate. The drawing discloses one chamber 11 for convenience.

The chamber 11 corresponds to an apparatus (furnace) having a space of an appropriate shape and generating crystals on surfaces of one or more silicon wafers 14 placed on a susceptor 13 inside the chamber 11. Accordingly, gas needed for crystal growth is introduced into the chamber 11 from a source gas tank (not shown) through a gas inflow path 16. Gas after a predetermined reaction is discharged to the outside of the chamber 11 through a gas outflow path 17. The chamber 11 is provided with a chamber window portion 18 made of quartz having excellent light transmissivity. The quartz chamber window portion 18 (quartz dome) is disposed directly above the silicon wafer 14 serving as the measurement target object and faces the silicon wafer 14.

In the chamber 11, heating units 25, 26, 27, and 28 that heat the silicon wafer 14 to a predetermined temperature, maintain the temperature, and cause the silicon wafer 14 to react with the gas are installed at appropriate locations outside the chamber 11. Each heating unit corresponds to a heat source that generates heat when energized, such as a halogen lamp or an infrared lamp.

To measure the temperature of the silicon wafer 14 (measurement target object, workpiece) placed on the susceptor 13 of the chamber 11, a temperature measurement unit (first temperature measurement unit) 21 is installed outside the chamber 11, specifically, directly above the chamber window portion 18. To measure the temperature of the chamber window portion 18 itself, a temperature measurement unit (second temperature measurement unit) 22 is installed at an appropriate location outside the chamber 11. Further, a temperature measurement unit (third temperature measurement unit) 24 for measuring the temperature of the susceptor 13 in the chamber 11 is installed at an appropriate location of a lower chamber portion 12 of the chamber 11. The temperature measurement units 21, 22, and 24 are non-contact thermometers referred to as pyrometers, for example, and are devices that measure an amount of radiance (amount of radiant heat, emissivity) of an object according to the Stefan-Boltzmann law and Planck's law. Further, a temperature adjustment unit 23 is provided to cool the chamber 11 after heating by the heating units 25 and other heating units and to suppress excessive heating in the chamber window portion 18. The temperature adjustment unit 23 corresponds to equipment such as a blower that sends air to a surface of the chamber 11.

In the illustrated temperature measurement device 1 and wafer production apparatus 2, the temperature measurement unit 21 is disposed outside the chamber window portion 18 installed in the chamber 11 and is used to measure the temperature of the silicon wafer 14 serving as the measurement target object through the chamber window portion 18. In addition to the temperature measurement unit 21, another temperature measurement unit may be installed outside the chamber 11.

In the wafer production apparatus 2, the temperature measurement unit 21, the temperature adjustment unit 23, and the heating units 25, 26, 27, and 28 are connected to the computer 10, and signals are transmitted between these units and the computer 10. Wiring for supplying electric power to the temperature measurement units 21 and 22, the temperature adjustment unit 23, and the heating units 25, 26, 27, and 28 is omitted from the drawings.

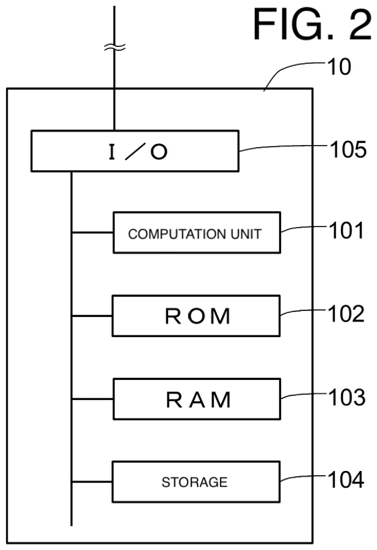

The temperature measurement device 1 includes the known computer 10 capable of performing arithmetic processing because the temperature measurement device 1 computes the temperature of the silicon wafer 14 serving as the measurement target object from the detection value of the temperature measurement unit 21. As shown in the block diagram of FIG. 2, the computer 10 includes, in terms of hardware, a computation unit 101 (central processing unit (CPU), graphics processing unit (GPU), and other components), read only memory (ROM) 102, random access memory (RAM) 103, storage 104, and other components, and is appropriately provided with an input-output interface (I/O) 105 and other components. The computer 10 is configured by various electronic computers (computing resources), such as known personal computers, supercomputers, mainframes, workstations, and cloud computing systems.

As shown in FIG. 1, the computer 10 includes a display (monitor) 4 for output, and a keyboard 5 and a mouse 6 for input. These components are connected to the I/O 105. The temperature measurement unit 21, the temperature adjustment unit 23, and the heating units 25, 26, 27, and 28 disclosed in FIG. 1 are connected to the I/O 105.

If the functional units of the computer 10 of the temperature measurement device 1 are implemented by software, the computer 10 implements the functions by executing instructions of a program that is software for implementing each function. A recording medium storing this program may be a non-transitory tangible medium, such as a compact disc (CD), a digital versatile disc (DVD), semiconductor memory, or a programmable logic circuit. The program may be supplied to the computer 10 of the temperature measurement device 1 through any transmission medium capable of transmitting the program, such as a communication network or a broadcast wave.

The storage 104 of the computer 10 of the temperature measurement device 1 includes a storage device such as a hard disk drive (HDD) or a solid state drive (SSD). Alternatively, the storage 104 may be an external server (not shown). The storage 104 stores various data, information, programs, and various pieces of data necessary for execution of the programs.

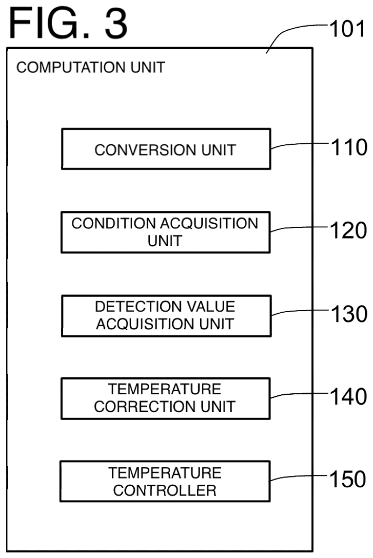

The functional units in the computation unit 101 of the computer 10 of the temperature measurement device 1 are shown in the schematic block diagram of FIG. 3. The functional units include a conversion unit 110, a condition acquisition unit 120, a detection value acquisition unit 130, a temperature correction unit 140, and a temperature controller 150 (wafer temperature controller that controls the temperature of the silicon wafer 14 serving as the measurement target object) as a configuration for executing temperature control. An output unit that executes processing necessary for output is also provided. Processing and execution in the temperature measurement device 1 and the wafer production apparatus 2 are implemented by a temperature measurement program and other software loaded into a main memory.

The conversion unit 110 generates conversion data of a temperature change amount of the silicon wafer 14 (measurement target object) heated in the chamber 11, the conversion data corresponding to a temperature change amount of the chamber window portion 18, on the basis of an actually measured temperature computed from the detection value of the temperature measurement unit 21. More specifically, the conversion unit 110 estimates a target temperature change amount of the measurement target object by excluding an influence of an amount of radiance caused by the chamber window portion from an actually measured temperature change amount computed from the detection value of the temperature measurement unit. The conversion unit 110 then generates conversion data from a correlation between the actually measured temperature change amount and the target temperature change amount.

The actually measured temperature change amount computed from the detection value of the temperature measurement unit 21 (first temperature measurement unit) is measurement of a so-called apparent temperature change. However, the actually measured temperature change amount cannot be considered to match the temperature of the silicon wafer 14 in the chamber 11. In particular, because the member of the chamber window portion 18 is present between the temperature measurement unit 21 and the silicon wafer 14, the influence of radiant heat from the member of the chamber window portion 18 inevitably occurs. Strictly speaking, a deviation occurs between the actually measured temperature in the heated state and the temperature of the silicon wafer 14. The conversion unit 110 generates conversion data to correct (calibrate) such a temperature deviation.

The condition acquisition unit 120 acquires the heating condition for the measurement target object (silicon wafer 14) in the chamber 11. Although the measurement target object according to the embodiment is a silicon wafer, epitaxial growth may be performed on a substrate made of another material. In this case, reference values such as an amount of radiance (amount of radiant heat, emissivity) differ for each material. Accordingly, as the heating condition, information regarding a temperature during epitaxial growth for the actual measurement target object, such as a reference value for each material and a temperature rise rate, is acquired.

The detection value acquisition unit 130 acquires the detection value of the temperature measurement unit 21. The temperature measurement unit 21 is a temperature measurement device such as a pyrometer and measures a target object as an amount of radiance. The temperature of the target is computed in the computation unit 101 of the computer 10 from the radiance during measurement.

The temperature correction unit 140 corrects the actually measured temperature computed from the detection value of the temperature measurement unit by using the conversion data generated by the conversion unit 110 and estimates the temperature of the measurement target object. The actually measured temperature change amount computed from the detection value of the temperature measurement unit 21 is corrected by the conversion data, thereby excluding the influence of the amount of radiance caused by the chamber window portion 18. Accordingly, a more accurate temperature of the silicon wafer 14 serving as the measurement target object is estimated.

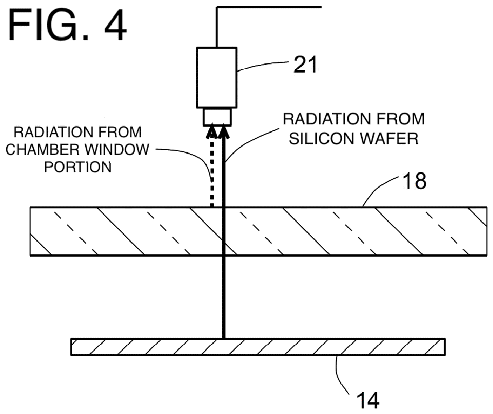

As shown in the schematic diagram of FIG. 4, if the temperature of the silicon wafer 14 serving as the measurement target object is measured from the outside of the chamber 11 by using the temperature measurement unit 21 such as a pyrometer, radiance actually measured by the temperature measurement unit 21 includes radiance of the silicon wafer 14 and radiance caused by the chamber window portion 18 constituting the chamber 11, and radiance obtained by mixing both is detected as the detection value. The chamber window portion 18 is made of quartz and has a uniform material. The radiance caused by the quartz chamber window portion 18 can be computed from the heating condition for the silicon wafer 14 serving as the measurement target object. Accordingly, the entire radiance is once computed through the temperature measurement unit 21, and then the influence of the radiance caused by the quartz chamber window portion 18 is subsequently excluded through the conversion data, thereby finally enabling temperature measurement of the silicon wafer 14 serving as the measurement target object.

Next, generation of the conversion data in the conversion unit 110 is described. The conversion data herein is data that indicates a correlation established between the actually measured temperature change amount and the target temperature change amount by estimating the target temperature change amount of the silicon wafer 14 after excluding the influence of the amount of radiance caused by the chamber window portion 18 from the actually measured temperature change amount computed from the detection value of the temperature measurement unit 21. The conversion data can be processed by numerical computation of a predetermined conversion equation.

The target temperature change amount refers to an apparent temperature change amount of the silicon wafer 14 serving as the measurement target object relative to the temperature change amount of the chamber window portion 18. For example, the target temperature change amount corresponds to an apparent temperature rise amount of the measurement target object if the temperature of the chamber window portion 18 rises by 10°C (+10°C) from a certain temperature.

At present, a temperature is measured through the chamber window portion by using a temperature measurement device such as a pyrometer, and the measured temperature is regarded as the temperature of the silicon wafer serving as the measurement target object. However, as described above, if the temperature of the chamber window portion changes, the apparent temperature of the silicon wafer changes. Accordingly, in control of the heating temperature for the silicon wafer when epitaxial growth is performed according to the type of gas introduced into the chamber, if the temperature of the chamber window portion changes over time due to equipment history such as repeated temperature rise and decrease, the temperature of the silicon wafer to be controlled apparently changes. As a result, the substantial temperature of the silicon wafer may change, and ideal epitaxial growth may not be formed.

The graphs of FIGS. 5A to 5C relate to a test in which the operation of the temperature adjustment unit was intentionally varied under control for maintaining the temperature of the silicon wafer constant by using the temperature measurement unit 21 (first temperature measurement unit). FIG. 5A shows a graph illustrating a change in the total output of the heating unit (halogen lamp) if the speed of the temperature adjustment unit is varied stepwise, with a horizontal axis representing time. Next, FIG. 5B shows a graph illustrating a change in the temperature of the chamber window portion if the speed of the temperature adjustment unit is varied stepwise with time, with a horizontal axis representing time. The temperature of the chamber window portion changes according to the speed of air blown out from the blower.

FIG. 5C shows a graph illustrating a relationship between the temperature of the chamber window portion and the total output of the heating unit (halogen lamp). Under control for maintaining constant the temperature measured through the chamber window portion, a good correlation is shown between the temperature of the chamber window portion and the output of the heating unit (halogen lamp). That is, if the temperature of the chamber window portion is intentionally changed under control for maintaining the temperature of the silicon wafer constant, the apparent temperature of the silicon wafer changes due to the influence of the temperature change of the chamber window portion, and, as a result, the output of the heating unit (halogen lamp) changes.

The graphs relating to the operation of the temperature adjustment unit in FIGS. 5A to 5C have a meaning of a preliminary test for determining the correction coefficient. Even if the speed (that is, air volume) of the temperature adjustment unit (fan) is intentionally changed and the temperature of the chamber window portion changes, a coefficient for correcting the temperature change at the chamber window portion may be determined so that the output becomes constant (that is, so that the apparent temperature of the silicon wafer does not change).

Thus, the temperature measurement device 1 and the wafer production apparatus 2 according to the embodiment are characterized by estimating, through computation while using conversion data prepared in advance, an inevitable deviation between the temperature change amount of the chamber window portion and the actual temperature change amount of the silicon wafer, and by controlling the temperature so that the temperature approaches an ideal heating temperature of the silicon wafer required for epitaxial growth.

A computation process in the conversion unit 110 according to the embodiment is as follows. Radiance (I_{w}) from the silicon wafer serving as the measurement target object at a temperature T_{w} and an emissivity ε_{w} is expressed as Equation (1), and radiance (I_{d}) from the chamber window portion 18 made of quartz at a temperature T_{d} and an emissivity ε_{d} is expressed as Equation (2). Radiance dependent on a measurement wavelength of the temperature measurement pyrometer is a composite of the following two radiances. In the equations, λ represents a monitoring wavelength of the pyrometer (temperature measurement unit 21), and is 3.4 µm. In the following equations, "C1" is hc², and C2 is hc. h represents Planck's constant, and c represents the speed of light.
Equation (1) ${I}_{w} = {ε}_{w} \left(\frac{2 C 1}{{λ}^{∧} 5}\frac{1}{exp \left(\frac{C 2}{λ \left(Tw+273.15\right)}\right) - 1}\right)$ (1) Equation (2) ${I}_{d} = {ε}_{d} \left(\frac{2 C 1}{{λ}^{5}}\frac{1}{exp \left(\frac{C 2}{λ \left(Td+273.15\right)}\right) - 1}\right)$ (2)

A radiance variation (ΔI_{d}) due to a temperature variation (ΔT_{d}) of the chamber window portion 18 made of quartz is expressed by Equation (3). Equation (4) is derived from Equation (2) and Equation (3).
Equation (3) $\begin{matrix}{I}_{d} + {ΔI}_{d} = \\ {ε}_{d} \left(\frac{2 C 1}{{λ}^{5}}\frac{1}{exp \left(\frac{C 2}{λ \left(Td+ΔTd+273.15\right)}\right) - 1}\right)\end{matrix}$ (3) Equation (4) ${ΔI}_{d} = {ε}_{d} \frac{2 C 1}{{λ}^{5}} \left(\frac{1}{exp \left(\frac{C 2}{λ \left(Td+ΔTd+273.15\right)}\right) - 1}-\frac{1}{exp \left(\frac{C 2}{λ \left(Td+273.15\right)}\right) - 1}\right)$ (4)

Based on ΔI_{d} in Equation (4), a relationship between an apparent temperature change of the silicon wafer and radiance I_{w}(T_{w} + ΔT_{w}) due to ΔT_{w} is expressed as Equation (5). In addition, radiance when the silicon wafer temperature is actually T_{w} + ΔT_{w} is expressed as Equation (6).
Equation (5) $\begin{matrix}{I}_{w} \left({T}_{w}+{ΔT}_{w}\right) = {I}_{w} + {ΔI}_{d} \\ = \frac{2 C 1}{{λ}^{5}} \left(\frac{{ε}_{w}}{exp \left(\frac{C 2}{λ \left(Tw+273.15\right)}\right) - 1}+\frac{{ε}_{d}}{exp \left(\frac{C 2}{λ \left(Td+ΔTd+273.15\right)}\right) - 1}-\frac{{ε}_{d}}{exp \left(\frac{C 2}{λ \left(Td+273.15\right)}\right) - 1}\right)\end{matrix}$ (5) Equation (6) ${I}_{w} \left({T}_{w}+{ΔT}_{w}\right) = {ε}_{w} \left(\frac{2 C 1}{{λ}^{5}}\frac{1}{exp \left(\frac{C 2}{λ \left(Tw+ΔTw+273.15\right)}\right) - 1}\right)$ (6)

The relationship between ΔT_{d} and ΔT_{w} is obtained from Equation (7).
Equation (7) $\begin{matrix}{ε}_{w} \left(\frac{2 C 1}{{λ}^{5}}\frac{1}{exp \left(\frac{C 2}{λ \left(Tw+ΔTw+273.15\right)}\right) - 1}\right) \\ = \frac{2 C 1}{{λ}^{5}} \left(\frac{{ε}_{w}}{exp \left(\frac{C 2}{λ \left(Tw+273.15\right)}\right) - 1}+\frac{{ε}_{d}}{exp \left(\frac{C 2}{λ \left(Td+ΔTd+273.15\right)}\right) - 1}-\frac{{ε}_{d}}{exp \left(\frac{C 2}{λ \left(Td+273.15\right)}\right) - 1}\right)\end{matrix}$ (7)

Equations (8) and the subsequent equations are equation transformations obtained by further advancing the computation of Equation (7). Equations (8), (9), and (10) are substitutions for simplifying the right-hand side of Equation (7). With respect to Equation (11), Equation (17) can be obtained by transforming Equation (11) in the order of Equations (12) to (16).
Equation (8) $A = exp \left(\frac{C 2}{λ \left(Tw+273.15\right)}\right)$ (8) Equation (9) $B = exp \left(\frac{C 2}{λ \left(Td+ΔTd+273.15\right)}\right)$ (9) Equation (10) $C = exp \left(\frac{C 2}{λ \left(Td+273.15\right)}\right)$ (10) Equation (11) ${ε}_{w} \left(\frac{1}{exp \left(\frac{C 2}{λ \left(Tw+ΔTw+273.15\right)}\right) - 1}\right) = \frac{{ε}_{w}}{A - 1} + \frac{{ε}_{d}}{B - 1} - \frac{{ε}_{d}}{C - 1}$ (11) Equation (12) $\frac{1}{exp \left(\frac{C 2}{λ \left(Tw+ΔTw+273.15\right)}\right) - 1} = \frac{1}{A - 1} + \frac{{ε}_{d}}{{ε}_{w}} \left(\frac{1}{B - 1}-\frac{1}{C - 1}\right)$ (12) Equation (13) $exp \left(\frac{C 2}{λ \left(Tw+ΔTw+273.15\right)}\right) - 1 = \frac{1}{\frac{1}{A - 1} + \frac{{ε}_{d}}{{ε}_{w}} \left(\frac{1}{B - 1}-\frac{1}{C - 1}\right)}$ (13) Equation (14) $\frac{C 2}{λ \left(Tw+ΔTw+273.15\right)} = LN \left(\frac{1}{\frac{1}{A - 1} + \frac{{ε}_{d}}{{ε}_{w}} \left(\frac{1}{B - 1}-\frac{1}{C - 1}\right)}+1\right)$ (14) Equation (15) $\begin{matrix}\frac{λ \left({T}_{w}+{ΔT}_{w}+273.15\right)}{C 2} \\ = \frac{1}{LN \left(\frac{1}{\frac{1}{A - 1} + \frac{{ε}_{d}}{{ε}_{w}} \left(\frac{1}{B - 1}-\frac{1}{C - 1}\right)}+1\right)}\end{matrix}$ (15) Equation (16) $\begin{matrix}λ \left({T}_{w}+{ΔT}_{w}+273.15\right) \\ = \frac{C 2}{LN \left(\frac{1}{\frac{1}{A - 1} + \frac{{ε}_{d}}{{ε}_{w}} \left(\frac{1}{B - 1}-\frac{1}{C - 1}\right)}+1\right)}\end{matrix}$ (16) Equation (17) $Δ {T}_{w} = \frac{C 2}{λ} \frac{1}{LN \left(\frac{1}{\frac{1}{A - 1} + \frac{{ε}_{d}}{{ε}_{w}} \left(\frac{1}{B - 1}-\frac{1}{C - 1}\right)}+1\right)} - \left({T}_{w}+273.15\right)$ (17)

Finally, ΔTw, which is the apparent temperature change amount of the silicon wafer, is obtained from Equation (17). In this way, in the temperature measurement device 1 and the wafer production apparatus 2 according to the embodiment, even in a temperature measurement state in which the chamber window portion 18 made of quartz is interposed and the temperature measurement unit 21 is used, the temperature change of the silicon wafer serving as the measurement target object can be grasped while excluding the influence of the radiance of the chamber window portion 18.

When the correlation between the temperature change of the chamber window portion 18 and the temperature change of the silicon wafer serving as the measurement target object is computed, the graph of FIG. 6 is obtained.

The horizontal axis represents a temperature change amount (°C) of the chamber window portion 18, and the vertical axis represents an apparent temperature change amount (°C) of the silicon wafer 14. The correlation between them is extremely high (can be approximated substantially as a straight line) and functions as conversion data under the heating condition.

Under the heating condition, the temperature T_{w} of the silicon wafer was set to 1100°C, the temperature T_{d} of the chamber window portion was set to 550°C, the emissivity ε_{w} of the silicon wafer was set to 0.6, the emissivity ε_{d} of the chamber window portion was set to 0.95, A-1 with respect to Equation (8) was set to 20.8, and C-1 with respect to Equation (10) was set to 169.9. In the same manner, high correlation is observed in verification of other silicon wafer temperatures and chamber window portion temperatures.

When the temperature of the silicon wafer is corrected on the basis of the temperature of the chamber window portion, a reference temperature of the quartz chamber window portion 18 is determined with respect to the set temperature of the silicon wafer on the basis of a measurement result of the temperature measurement unit (second temperature measurement unit) 22 installed separately from the temperature measurement unit (first temperature measurement unit) 21. A difference between an actually measured result of the temperature of the quartz chamber window portion 18 and the reference temperature of the same window portion is computed. The temperature of the silicon wafer is then corrected by using a coefficient on the basis of linear regression (linear correlation).

In actual equipment and materials, variations in emissivity (ε_{d}, ε_{w}) and variations among pieces of equipment such as chambers are unavoidable. Accordingly, variation is expected to occur in the value of the temperature correction of the chamber window portion. In view of this point, the reference temperature of the chamber window portion is determined on the basis of a sufficiently reliable number of pieces of temperature measurement data during process running in an actual production stage. Then, adjustment is performed by multiplying a correction value obtained based on computation by a coefficient. The reference temperature of the silicon wafer corresponds to the set temperature to be controlled.

For temperature correction, the conversion equation shown in FIG. 6, which approximates a linear correlation (linear regression), is used. When the coefficient of the linear correlation (linear regression) is determined, the apparatus is set to a state in which correction can be performed by a value determined in advance through computation. In this state, while the temperature of the silicon wafer is controlled to be constant by the temperature measurement unit 21 (first temperature measurement unit), the speed (air velocity) of the temperature adjustment unit is changed to change the temperature of the chamber window portion. The total output of the heating unit (halogen lamp) is monitored, and the correction coefficient is determined so that fluctuation in the total output does not occur. If fluctuation in the total output is observed, the coefficient by which the set correction value is multiplied is adjusted to reduce the fluctuation in the total output, and the coefficient that produces the smallest fluctuation in the total output is finally determined. Alternatively, the correction coefficient may be determined so that, even if the temperature of the chamber window portion changes due to intentional change of the speed (that is, air volume) of the temperature adjustment unit (blower, fan) while the output is kept constant, the temperature of the silicon wafer does not change.

In the graph shown in FIG. 6, the temperature change amount (°C) of the chamber window portion 18 on the horizontal axis is denoted by "ΔT_{d}," and the temperature change amount (°C) of the silicon wafer 14 on the vertical axis is denoted by "ΔT_{w}." From linear regression, this relationship is expressed by the equation "ΔT_{w} = a × ΔT_{d}." a is a coefficient. a is set so that fluctuation in the total output is eliminated if the air velocity of the temperature adjustment unit (blower) is changed.

As described above, the temperature change of the silicon wafer serving as the measurement target object can be estimated by correcting the actually measured temperature computed from the detection value of the temperature measurement unit 21 by using the conversion data. Accordingly, in the temperature measurement device 1 according to the embodiment, specifically in the wafer production apparatus 2, the temperature controller 150 is provided in the computation unit 101. The temperature controller 150 controls the temperature of the silicon wafer 14 serving as the measurement target object, which is estimated by the temperature correction unit 140.

Based on the above, the temperature measurement program in the computer 10 (computation unit 101) of the temperature measurement device 1 and the wafer production apparatus 2 according to the embodiment will be described using the flowchart of FIG. 7. The temperature measurement method is executed by the computation unit 101 (arithmetic element) of the computer 10 based on the temperature measurement program.

The temperature measurement program causes the computer 10 (shown in FIG. 2) to execute a conversion function, a condition acquisition function, a detection value acquisition function, a temperature correction function, and a temperature control function. Although not described here, functions necessary for the device, such as an output function, are naturally included and executed. Because the details of each function overlap with the description of the temperature measurement device 1 above, the details are omitted here.

As shown in the flowchart of FIG. 7, processing by the computation unit 101 (arithmetic element) of the computer 10 includes various steps, namely, a conversion step (S110), a condition acquisition step (S120), a detection value acquisition step (S130), a temperature correction step (S140), and a temperature control step (S150). Various steps necessary for operation of the computer 10 itself are naturally included.

The conversion function generates conversion data of the temperature change amount of the measurement target object (silicon wafer 14) heated in the chamber 11, the conversion data corresponding to the temperature change amount of the chamber window portion 18, on the basis of the actually measured temperature computed from the detection value of the temperature measurement unit 21 (S110: conversion step). The condition acquisition function acquires the heating condition for the measurement target object (silicon wafer 14) in the chamber 11 (S120: condition acquisition step). The detection value acquisition function acquires the detection value of the temperature measurement unit 21 (S130: detection value acquisition step). The temperature correction function corrects the actually measured temperature computed from the detection value of the temperature measurement unit 21 by using the conversion data and estimates the temperature of the measurement target object (silicon wafer 14) (S140: temperature correction step). In the case in which the temperature controller 150 is provided, the temperature control function controls the temperature of the measurement target object (silicon wafer 14) estimated by the temperature correction function (S150: temperature control step).

The computer program of the present invention described above may be recorded on a processor-readable recording medium. As the recording medium, a non-transitory tangible medium, such as a disk, a card, semiconductor memory, or a programmable logic circuit, may be used.

The computer program described above may be implemented by using scripting languages such as ActionScript and JavaScript (registered trademark), object-oriented programming languages such as Objective-C and Java (registered trademark), or markup languages such as HTML5, for example.

### Example

The present inventors performed epitaxial growth on a silicon wafer by using the temperature measurement device, temperature measurement method, and temperature measurement program disclosed in the above embodiment in a wafer production apparatus actually including a temperature measurement device (pyrometer), and performed measurement. As a result, the present inventors verified effectiveness of the temperature measurement device (method and program) according to the embodiment.

FIGS. 8A to 9B show results of temperature measurement obtained by changing the "coefficient a" in the linear regression equation shown in FIG. 6 ("ΔT_{w} = a × ΔT_{d}") on the basis of values derived from the computation equation described above. In FIGS. 8A to 9B, FIGS. 8A and 9A each show a graph of a measured temperature of the first temperature measurement unit and a speed of the temperature adjustment unit (horizontal axis: time; left vertical axis: temperature (°C); right vertical axis: temperature (K)). In FIGS. 8A to 9B, FIGS. 8B and 9B each show a graph of the measured temperature of the first temperature measurement unit and the measured temperature of the second temperature measurement unit (horizontal axis: time; left vertical axis: temperature (°C); right vertical axis: temperature (°C)).

As shown in FIG. 8A, if the speed of the temperature adjustment unit (blower) decreases stepwise, the measured temperature (so-called apparent temperature) of the first temperature measurement unit (for measuring the silicon wafer), for which coefficient correction has not been performed, rises. That is, if the operation of the temperature adjustment unit (blower) becomes weaker (that is, the air volume decreases), the air-cooling effect decreases, and a temperature rise occurs. As shown in FIG. 8B, the measured temperature of the first temperature measurement unit (for measuring the silicon wafer) corresponds to the temperature change of the chamber window portion (quartz dome), which changes in response to the change in the speed of the temperature adjustment unit. FIGS. 9A and 9B also show similar tendencies in the graphs.

Here, FIGS. 8A and 8B show results when the coefficient was adjusted to 0.2. Portions enclosed by dashed lines in FIGS. 8A and 8B indicate temperature values at points where measurement values of the pyrometer of the first temperature measurement unit (for measuring the silicon wafer) were corrected. In FIG. 8A, the temperature is substantially constant at each correction point regardless of the speed of the temperature adjustment unit (blower). In FIG. 8B, the temperature is substantially constant at each correction point without being affected by the temperature value of the second temperature measurement unit (for measuring the chamber window) (for measuring the quartz dome).

In contrast with FIGS. 8A and 8B, FIGS. 9A and 9B show results when the coefficient was adjusted to 0.1. Portions enclosed by dashed lines in FIGS. 9A and 9B indicate temperature values at points where measurement values of the pyrometer of the first temperature measurement unit (for measuring the silicon wafer) were corrected. In FIG. 9A, the chamber temperature changes (rises) in conjunction with the speed of the temperature adjustment unit (blower), that is, as the speed decreases. As a result, the temperature value at each correction point rises in conjunction with the chamber temperature. In FIG. 9B, the temperature value at each correction point rises due to a change (temperature rise) in the temperature value of the second temperature measurement unit (for measuring the chamber window) (for measuring the quartz dome). Under the coefficient value condition of FIGS. 9A and 9B, the influence of the temperature change of the chamber (quartz dome) on the first temperature measurement unit (for measuring the silicon wafer) can still be recognized.

Accordingly, from comparison of the graphs of FIGS. 8A to 9B, if the temperature of the silicon wafer heated in the chamber (quartz dome) is measured by the pyrometer of the first temperature measurement unit (for measuring the silicon wafer), an appropriate coefficient value can be selected to reduce the influence of the temperature of the chamber (quartz dome) and other factors and to compute a more accurate temperature value.

In the graph shown in FIG. 10, an upper portion shows time-series changes in temperature measurement values from the pyrometer of the first temperature measurement unit (for measuring the silicon wafer) and the second temperature measurement unit (for measuring the chamber window) (for measuring the quartz dome). A lower portion shows time-series changes in temperature measurement values from the pyrometer of the first temperature measurement unit (for measuring the silicon wafer) and an output value (kW) of the heating unit. Here, the left side in the drawing shows a graph waveform when the correction function is activated for the first temperature measurement unit (for measuring the silicon wafer), and the portion from the center to right side in the drawing shows a graph waveform when the correction function is deactivated for the first temperature measurement unit (for measuring the silicon wafer).

In an actual epitaxial growth process of the silicon wafer, the temperature of the chamber (quartz dome) changes according to temperature rise and decrease of the process temperature. If the correction function is stopped (not activated), even after the silicon wafer temperature stabilizes, the heating output decreases in response to a change in the temperature of the chamber (quartz dome) (see the oblique dashed line on the lower right side). This occurs because, as the temperature of the chamber (quartz dome) rises, the temperature measured by the pyrometer (radiation thermometer) that monitors the silicon wafer appears higher than the actual temperature of the wafer, and the heating output decreases in response to the apparent rise in the wafer temperature. As a result, the heat applied to the silicon wafer decreases even though the heating output should originally be maintained or increased, which is problematic.

To address this, the correction function acts on the temperature measurement value of the first temperature measurement unit (for measuring the silicon wafer) on the basis of the temperature measurement value of the second temperature measurement unit (for measuring the chamber window) (for measuring the quartz dome). This mitigates the influence of the temperature change of the chamber (quartz dome), accurately estimates the temperature of the silicon wafer inside the chamber, and enables necessary heating. As indicated by the dashed line on the lower left side of FIG. 10, the heating output is clearly maintained constant while the correction function is activated.

### Description of Reference Numerals

1: Temperature Measurement Device
2: Wafer Production Apparatus
4: Display (Monitor)
10: Computer
11: Chamber
12: Lower Chamber Portion
13: Susceptor
14: Silicon Wafer
18: Chamber Window Portion
21: Temperature Measurement Unit (First Temperature Measurement Unit)
22: Temperature Measurement Unit (Second Temperature Measurement Unit)
23: Temperature Adjustment Unit
25, 26, 27, 28: Heating Unit
101: Computation Unit
102: Rom
103: Ram
104: Storage
105: I/O
110: Conversion Unit
120: Condition Acquisition Unit
130: Detection Value Acquisition Unit
140: Temperature Correction Unit
150: Temperature Controller

## Claims

1. A temperature measurement device comprising: a chamber of an epitaxial growth apparatus, the chamber housing a measurement target object therein; a heating unit that heats the measurement target object; a chamber window portion provided at a position of the chamber facing the measurement target object; a temperature measurement unit installed outside the chamber window portion of the epitaxial growth apparatus and configured to measure a temperature of the measurement target object through the chamber window portion and to measure a temperature of the chamber window portion; and a computation unit that computes the temperature of the measurement target object from a detection value of the temperature measurement unit,
wherein the computation unit comprises:
a conversion unit that generates conversion data of a temperature change amount of the measurement target object heated in the chamber, the conversion data corresponding to a temperature change amount of the chamber window portion, on the basis of an actually measured temperature computed from the detection value of the temperature measurement unit;
a condition acquisition unit that acquires a heating condition for the measurement target object in the chamber;
a detection value acquisition unit that acquires the detection value of the temperature measurement unit; and
a temperature correction unit that corrects the actually measured temperature computed from the detection value of the temperature measurement unit by using the conversion data and estimates the temperature of the measurement target object.

2. The temperature measurement device according to claim 1, wherein the conversion unit estimates a target temperature change amount of the measurement target object by excluding an influence of an amount of radiance caused by the chamber window portion from an actually measured temperature change amount computed from the detection value of the temperature measurement unit, and
generates the conversion data from a correlation between the actually measured temperature change amount and the target temperature change amount.

3. The temperature measurement device according to claim 1, wherein the heating unit is provided outside the chamber, and
the computation unit comprises:
a temperature controller that controls an output of the heating unit on the basis of the temperature of the measurement target object estimated by the temperature correction unit.

4. The temperature measurement device according to claim 1, wherein the measurement target object is a silicon wafer.

5. The temperature measurement device according to claim 1, wherein the chamber window portion is made of quartz.

6. The temperature measurement device according to claim 1, wherein a temperature adjustment unit that cools the chamber is provided outside the chamber.

7. A temperature measurement method executed by a computation unit in a temperature measurement device including a chamber of an epitaxial growth apparatus, the chamber housing a measurement target object therein, a heating unit that heats the measurement target object, a chamber window portion provided at a position of the chamber facing the measurement target object, a temperature measurement unit installed outside the chamber window portion of the epitaxial growth apparatus and configured to measure a temperature of the measurement target object through the chamber window portion and to measure a temperature of the chamber window portion, and the computation unit that computes the temperature of the measurement target object from a detection value of the temperature measurement unit, the temperature measurement method comprising:
a conversion step of generating conversion data of a temperature change amount of the measurement target object heated in the chamber, the conversion data corresponding to a temperature change amount of the chamber window portion, on the basis of an actually measured temperature computed from the detection value of the temperature measurement unit;
a condition acquisition step of acquiring a heating condition for the measurement target object in the chamber;
a detection value acquisition step of acquiring the detection value of the temperature measurement unit; and
a temperature correction step of correcting the actually measured temperature computed from the detection value of the temperature measurement unit by using the conversion data and estimating the temperature of the measurement target object.

8. A temperature measurement program that causes a computer in a temperature measurement device to execute processing, the temperature measurement device including a chamber of an epitaxial growth apparatus, the chamber housing a measurement target object therein, a heating unit that heats the measurement target object, a chamber window portion provided at a position of the chamber facing the measurement target object, a temperature measurement unit installed outside the chamber window portion of the epitaxial growth apparatus and configured to measure a temperature of the measurement target object through the chamber window portion and to measure a temperature of the chamber window portion, and a computation unit that computes the temperature of the measurement target object from a detection value of the temperature measurement unit, the processing comprising:
a conversion function of generating conversion data of a temperature change amount of the measurement target object heated in the chamber, the conversion data corresponding to a temperature change amount of the chamber window portion, on the basis of an actually measured temperature computed from the detection value of the temperature measurement unit;
a condition acquisition function of acquiring a heating condition for the measurement target object in the chamber;
a detection value acquisition function of acquiring the detection value of the temperature measurement unit; and
a temperature correction function of correcting the actually measured temperature computed from the detection value of the temperature measurement unit by using the conversion data and estimating the temperature of the measurement target object.

9. A wafer production apparatus comprising: a chamber of an epitaxial growth apparatus, the chamber housing a silicon wafer therein;
a heating unit that heats the silicon wafer;
a chamber window portion made of quartz and provided at a position of the chamber facing the silicon wafer;
a temperature measurement unit installed outside the chamber window portion of the epitaxial growth apparatus and configured to measure a temperature of a measurement target object through the chamber window portion and to measure a temperature of the chamber window portion; and
a computation unit that computes the temperature of the silicon wafer from a detection value of the temperature measurement unit,
wherein the computation unit comprises:
a conversion unit that generates conversion data of a temperature change amount of the silicon wafer heated in the chamber, the conversion data corresponding to a temperature change amount of the chamber window portion, on the basis of an actually measured temperature computed from the detection value of the temperature measurement unit;
a condition acquisition unit that acquires a heating condition for the silicon wafer in the chamber;
a detection value acquisition unit that acquires the detection value of the temperature measurement unit; and
a temperature correction unit that corrects the actually measured temperature computed from the detection value of the temperature measurement unit by using the conversion data and estimates the temperature of the silicon wafer.

10. The wafer production apparatus according to claim 9, wherein the heating unit is provided outside the chamber, and
the computation unit comprises:
a temperature controller that controls an output of the heating unit on the basis of the temperature of the measurement target object estimated by the temperature correction unit.

11. The wafer production apparatus according to claim 9, wherein a temperature adjustment unit that cools the chamber is provided outside the chamber.

12. The wafer production apparatus according to claim 10, wherein the temperature adjustment controller performs feedback control.
